# FASCICULE DE BREVET EUROPEEN

(11) **EP 0 342 085 B1**
(45) Date de publication et mention de la délivrance du brevet: **10.03.1993**
(21) Numéro de dépôt: 89401164.2
(22) Date de dépôt: 25.04.1989
(51) Int. Cl.: H01H 1/40, H01R 9/09

(54) **Connecteur électrique et circuit imprimé comportant un tel connecteur**
Elektrischer Verbinder und gedruckte Schaltung mit einem solchen Verbinder
Electric connector and printed circuit comprising such a connector

(30) Priorité: 13.05.1988 FR 8806463
(43) Date de publication de la demande: 15.11.1989
(73) Titulaire: GERARD MANG S.A., F-75010 Paris (FR)
(72) Inventeur: Marchesseau, Jack, F-78120 Rambouillet (FR)
(74) Mandataire: Boutin, Antoine

(56) Documents cités:
- DE-A- 2 413 989
- DE-B- 1 208 780
- FR-A- 1 422 508
- US-A- 2 039 957

## Description

La présente invention concerne les connecteurs électriques de faible encombrement qui sont susceptibles de diverses applications et notamment d'équiper des circuits imprimés. Un tel connecteur est par exemple décrit dans le document US-A-2039957.

Dans ce dernier cas les connecteurs utilisés sont destinés à établir ou à interrompre le passage d'un courant entre deux pistes d'un circuit imprimé. Les connecteurs actuels de ce genre sont habituellement constitués par une lame métallique flexible dont une extrémité est fixée sur l'une des pistes du circuit correspondant, cependant que son extrémité libre opposée s'appuie normalement sur une autre piste de ce même circuit. L'interruption de la connexion correspondante est réalisée en interposant un écran mince en matière isolante entre l'extrémité libre de la lame électrique et la piste sur laquelle celle-ci s'applique normalement.

Cependant les connecteurs actuels de ce genre présentent un encombrement relativement important. Ceci est dû au fait que la flexibilité de l'extrémité libre de la lame de connexion ne peut être obtenue qu'au prix d'une longueur importante de cette lame. Pour réduire la longueur d'une telle lame, il a déjà été proposé d'ajouter un organe élastique supplémentaire assurant le maintien de la lame sur la piste correspondante du circuit imprimé. Cependant cette solution introduit une complication et elle est également encombrante. Par ailleurs dans tous les cas le montage d'un connecteur du type en cause est rendu difficile par le fait que le moment de flexion dans la lame étant maximum au droit de son point de fixation sur le circuit imprimé, une simple soudure s'avère insuffisante, de sorte que l'on est donc conduit à réaliser l'assemblage au moyen de vis, rivets, sertissages, etc...

C'est pourquoi la présente invention a pour but de remédier aux inconvénients exposés ci-dessus des connecteurs actuels de ce genre. A cet effet, elle a pour premier but de réduire l'encombrement de tels connecteurs tout en permettant néanmoins une flexibilité importante de la lame de connexion correspondante. Cependant l'invention a également pour but de permettre la fixation de l'extrémité correspondante de cette lame par simple soudure sans qu'il soit nécessaire de prévoir des moyens complémentaires d'assemblage, et ce tout en facilitant du reste la réalisation de cette opération de soudure.

A cet effet, l'invention a pour objet un connecteur du type en cause qui est caractérisé en ce que :
- la lame élastique de connexion de celui-ci affecte la forme d'un S couché dont les extrémités portent chacune une patte coudée ou courbée dont l'une forme l'extrémité de fixation de cette lame sur un élément du circuit, cependant que l'autre constitue le contact mobile disposé contre un autre élément du circuit,
- le support des éléments du circuit consiste en une plaque relativement peu épaisse, celle-ci présente une ouverture quadrangulaire, située en regard de la lame élastique de connexion, et à travers laquelle est engagée la première boucle formée par cette lame du voisinage de son extrémité de fixation, la dimension de cette ouverture dans le sens longitudinal étant inférieure à la largeur maximum de la boucle correspondante de la lame de connexion avant la mise en place de la lame.

Ainsi, du fait même de la forme très particulière prévue pour la lame de connexion, celle-ci possède une flexibilité importante tout en présentant un encombrement restreint dans le sens de la longueur. Par ailleurs, l'agencement prévu permet que la fixation de cette lame soit réalisée par simple soudure. De plus cet agencement facilite l'exécution de cette opération.

Du reste les particularités et avantages de l'objet de l'invention apparaîtront au cours de la description suivante.

Celle-ci est donnée en référence au dessin annexé à simple titre indicatif, et sur lequel :
La figure 1 est une vue en perspective d'un connecteur selon l'invention dans sa position normale.
Les figures 2 et 3 sont des vues similaires représentant ce même connecteur, respectivement lors de l'interruption de la connexion correspondante par interposition d'un écran isolant, et lors de la réalisation d'une connexion avec un élément extérieur au circuit correspondant.
La figure 4 est une vue schématique en coupe-élévation illustrant le mode de montage de la lame de connexion prévue dans le présent connecteur.
La figure 5 est une vue similaire illustrant le mode de déformation de cette lame lors de l'engagement d'un écran ou autre élément mobile sous l'extrémité libre de celle-ci.

Le connecteur représenté à titre d'exemple sur ces figures est destiné à établir ou à interrompre le passage d'un courant entre deux pistes 1 et 2 d'un circuit imprimé porté par un support constitué par une plaque isolante 3 relativement peu épaisse. Conformément à la caractéristique essentielle de l'objet de l'invention, ce connecteur comporte une lame élastique de connexion 4 en métal qui présente la particularité d'affecter la forme d'un S couché dont les extrémités portent chacune une patte 5 ou 6. la première de ces deux pattes est simplement coudée pour former l'extrémité de fixation de la lame correspondante. Quant à l'autre patte 6, elle est incurvée comme représenté sur les dessins afin de constituer le contact mobile de la lame de connexion, lequel est disposé en regard de la piste 2 du circuit correspondant. Du fait de sa forme en S, la lame 4 présente deux boucles successives 7 et 8 dont la concavité est tournée en sens inverse.

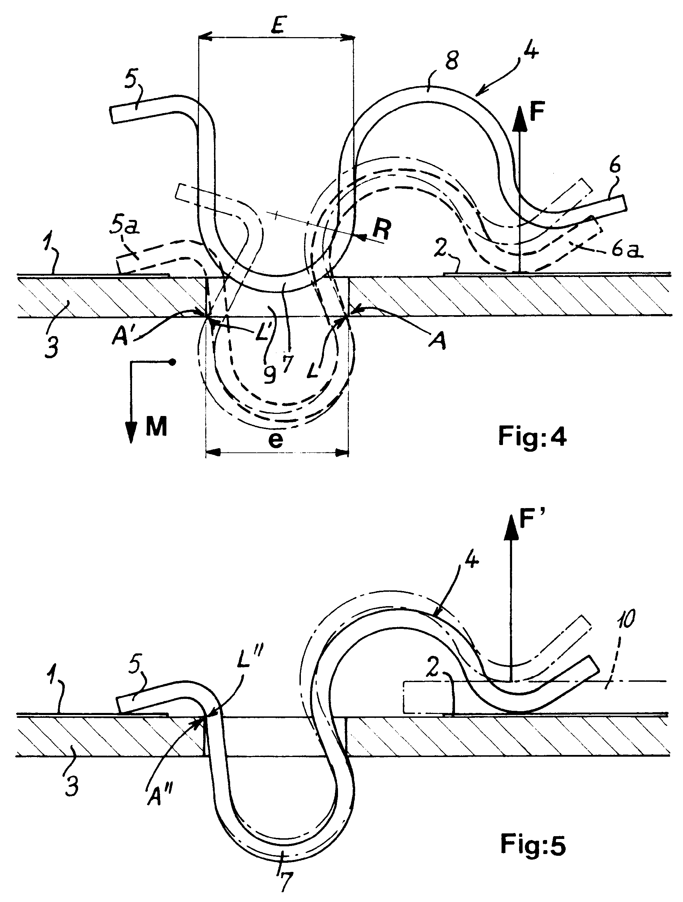

Quant au support 3 des pistes du circuit imprimé, il présente la particularité de comporter une ouverture quadrangulaire 9 en regard de la position de la lame élastique 4, et ce à proximité du point de fixation de son extrémité 5. Cette ouverture est destinée à recevoir la première boucle 7 de cette lame. A cet effet, la largeur de cette ouverture n'est que très légèrement supérieure à la largeur de cette lame. Quant à sa longueur "e" dans le sens longitudinal, elle est par contre inférieure à la largeur maximum E de la première boucle 7 de cette lame à l'état de repos (voir figure 4).

En conséquence pour monter en place cette lame de connexion, il convient d'engager à force la première boucle 7 de celle-ci à travers l'ouverture 9 comme représenté sur la figure 4, jusqu'à ce que les pattes 5 et 6 de ses extrémités soient disposées au contact respectivement de la piste 1 et de la piste 2, dans les positions 5a et 6a. La première boucle 7 se trouve alors située au-delà de l'ouverture 9 et fait saillie par rapport à la face de la plaque 3 qui est opposée à celle portant les pistes 1 et 2. Sur la figure 4, le tracé en traits forts représente la lame 4 avant son montage en place, le tracé en traits mixtes illustre la forme de celle-ci pendant son insertion dans l'ouverture 9 et enfin, le tracé en pointillés représente cette lame après achèvement de sa mise en place.

A ce sujet, il convient de noter que la première boucle 7 destinée à être engagée à travers l'ouverture 9 est conformée avec un rayon R, tel que 2R soit légèrement supérieur à la longueur "e" de l'ouverture 9. Cette boucle se déforme élastiquement pendant le montage et permet, dès son insertion dans l'ouverture 9, l'apparition de deux lignes de pression L, L′ le long des arêtes A et A′ de l'ouverture 9. Ceci assure donc le maintien en place de la lame de connexion sur la plaque 3 de support.

Par ailleurs, sitôt que la lame de connexion est poussée à fond dans sa position définitive, la réaction d'appui F de la piste 2 sur la patte 6 de son extrémité libre provoque l'apparition d'un moment de flexion M. Or celui-ci tend à faire pivoter la première boucle 7 sur elle-même en renforçant ainsi l'appui de la ligne L sur l'arête A et en transformant l'appui L′ sur l'arête A′ en un appui de la ligne L˝ sur l'arête A" située sur la face opposée de la plaque 3, c'est-à-dire celle qui porte les pistes 1 et 2 du circuit imprimé. En conséquence ceci assure l'application de la patte d'extrémité 5 contre la piste 1 en libérant ainsi le point de fixation correspondant de toute contrainte mécanique d'arrachement.

Dans ces conditions, il est possible de réaliser la fixation de la patte 5 par une simple soudure sans qu'il soit nécessaire de prévoir des moyens supplémentaires d'assemblage. Par ailleurs, l'exécution de cette soudure se trouve grandement facilitée puisque pendant celle-ci la patte 5 se trouve déjà maintenue fermement appliquée contre la piste 1, ainsi qu'il a été expliqué précédemment.

Il s'agit donc là d'un avantage essentiel du connecteur selon l'invention. Cependant un autre avantage important de celui-ci réside dans le fait que la lame de connexion 4 possède une flexibilité importante tout en présentant un encombrement réduit. Ceci tient au fait que grâce aux ondulations prévues sur cette lame, l'encombrement de celle-ci dans le sens de la longueur est très limité alors que la longueur effective de cette lame est par contre importante. Ceci permet de disposer d'une très grande flexibilité de l'extrémité libre de cette lame lors de l'insertion d'un élément d'interposition 10 entre sa patte 6 et la piste correspondante 2 du circuit.

De plus, comme il ressort de la figure 5, l'insertion d'un tel élément d'interposition 10 a pour effet que l'action des différents appuis mentionnés plus haut se trouve alors renforcée par l'augmentation de la réaction d'appui F′ par rapport à F. Ceci tend encore à renforcer la sécurité du montage. Sur cette figure 5, la position initiale de la lame 4 avant insertion de l'élément d'interposition 10 est représentée en traits pleins cependant que la forme de cette lame après mise en place de cet élément est représentée en traits mixtes.

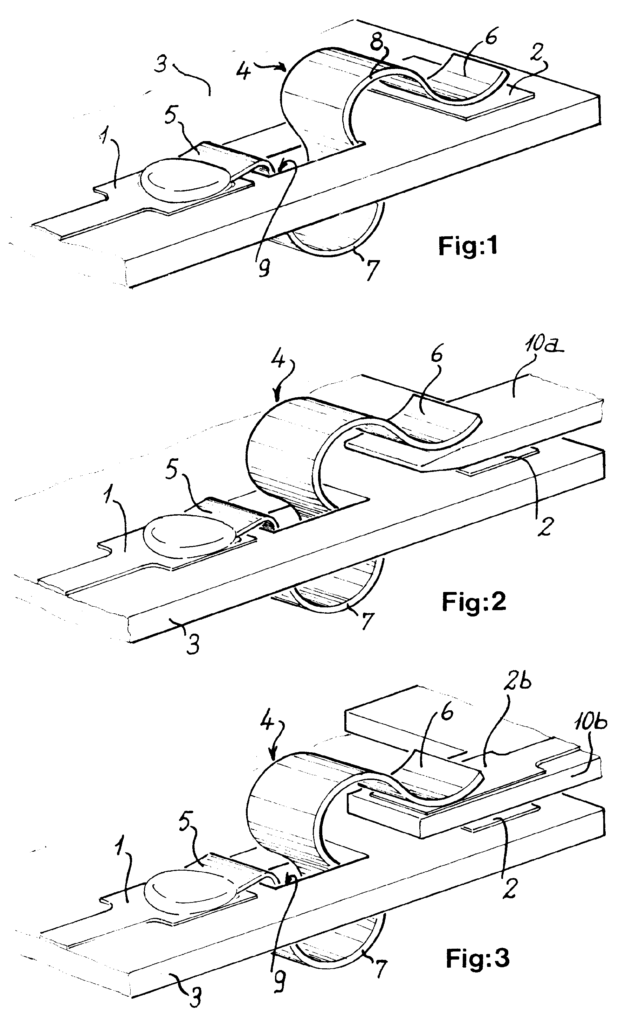

Les figures 2 et 3 illustrent deux modes différents d'utilisation du présent connecteur. Dans le cas représenté à la figure 2, un écran isolant 10a est inséré entre la patte d'extrémité 6 de la lame 4 et la piste correspondante 2 de façon à interrompre la liaison électrique correspondante. Dans le cas illustré à la figure 3, c'est un élément 10b d'un circuit de raccordement avec un appareil extérieur qui est inséré entre la patte 6 et la piste 2. Or, la face supérieure de cet élément porte une piste conductrice 2b qui se trouve ainsi en contact avec la patte 6, ce qui établit une liaison électrique entre cette piste et la piste 1 du premier circuit considéré. Dans un tel cas, le présent connecteur permet d'assurer la jonction de la piste 1 avec le circuit d'un appareil extérieur de nature quelconque.

Cependant les deux cas illustrés ci-dessus ne constituent que des exemple d'utilisation du présent connecteur. Par ailleurs, il convient de noter que l'invention a pour objet non seulement ce connecteur considéré en lui-même, mais également les circuits imprimés équipés d'un ou plusieurs connecteurs ainsi constitués.

Toutefois, le connecteur selon l'invention peut être employé pour des applications autre que l'équipement de circuits imprimés. En effet un tel connecteur peut être employé dans de nombreux autres cas d'application soit isolément, soit par groupe de plusieurs connecteurs.

## Revendications

1. Connecteur électrique comportant une lame (4) métallique élastique de connexion dont une extrémité est fixée par soudure sur un élément (1) d'un circuit, par exemple une piste conductrice d'un circuit imprimé, cependant que son extrémité libre opposée s'applique sur un autre élément du circuit correspondant et peut en être isolé par insertion d'un écran isolant, caractérisé en ce que :
- la lame (4) élastique de connexion affecte la forme d'un S couché dont les extrémités portent chacune une patte (5, 6) coudée ou courbée dont l'une (5) forme l'extrémité de fixation de cette lame (4) sur un élément (1) du circuit, cependant que l'autre (6) constitue le contact mobile disposé contre un autre élément (2) du circuit,
- le support des éléments (1, 2) du circuit consiste en une plaque (3) relativement peu épaisse, celle-ci présente une ouverture (9), située en regard de la lame (4) élastique de connexion, et à travers laquelle est engagée la première boucle (7) formée par cette lame (4) au voisinage de sa patte d'extrémité de fixation (5), la dimension (e) de cette ouverture (9) dans le sens longitudinal étant inférieure à la largeur maximum (E) de la boucle correspondante (7) de la lame (4) de connexion avant la mise en place de la lame (4).

2. Connecteur électrique selon la revendication 1, caractérisé en ce qu'à la place d'un simple écran isolant, destiné à être inséré sous la patte de l'extrémité libre (6) de la lame (4) élastique de connexion, il est prévu un élément mobile (10b) portant une piste conductrice (2b) de raccordement avec un appareil extérieur, de sorte que l'insertion de cet élément (10b) sous l'extrémité libre de la lame (4) de connexion permet d'assurer un raccordement avec cet appareil extérieur.

3. Circuit électrique imprimés comportant plusieurs pistes raccordées par des connecteurs à lame élastique (4), caractérisé en ce que ceux-ci sont constitués par des connecteurs selon la revendication 1 ou 2.

## Patentansprüche

1. Elektrischer Verbinder mit einer elastischen Verbindungszunge (4) am Metall, deren eines Ende auf einem Element (1) einer Schaltung, z. B. auf einer Leiterbahn einer gedruckten Schaltung, durch eine Verbindungslötung fixiert ist, während deren anderes freies Ende sich auf ein anderes Element der betreffenden Schaltung auflegt und davon durch Einbringen eines Isolierschiebers isoliert werden kann, dadurch gekennzeichnet, daß
- die elastische Verbindungszunge (4) eine liegende S-Form aufweist und ihre Enden jeweils einen gekrümmten oder gebogenen Fortsatz (5, 6) tragen, von denen der eine (5) das Fixierende der Verbindungszunge (4) auf einem Element (1) der Schaltung bildet, während der andere den beweglichen Kontakt zu dem anderen Element (2) der Schaltung darstellt,
- der Träger der Elemente (1, 2) der Schaltung aus einer Platte (3) relativ geringer Dicke besteht, die eine Durchbrechung (9) aufweist,die gegenüberliegend zu der elastischen Verbindungszunge (4) angeordnet ist und durch die sich die erste Krümmung (7) der Verbindungszunge (4) im Anschluß an den der Fixierung dienenden Fortsatz (5) erstreckt, wobei die Abmessung (e) der Durchbrechung (9) in Längsrichtung kleiner als die maximale Weite (E) der betreffenden Krümmung (7) der Verbindungszunge (4) vor ihrer Montage ist.

2. Elektrischer Verbinder nach Anspruch 1, dadurch gekennzeichnet, daß anstelle eines einfachen Isolierschiebers zum Einbringen unter den Fortsatz (6) am freien Ende der Verbindungszunge (4) ein bewegliches Element (10 b) mit einer Leiterbahn (2 b) zum Verbinden mit einem externen Gerät in der Weise vorgesehen ist, daß das Einbringen dieses Elementes (10 b) unter das freie Ende der Verbindungszunge (4) eine Verbindung mit dem externen Gerät erbringt.

3. Gedruckte elektrische Schaltung mit mehreren Leiterbahnen, die über Verbinder mit elastischen Verbindungszungen (4) verbunden sind, dadurch gekennzeichnet, daß diese aus Verbindern nach den Ansprüchen 1 oder 2 bestehen.

## Claims

1. An electric connector comprising a resilient metallic connecting blade (4) one end of which is fixed by soldering onto an element (1) of a circuit, for instance a conductive track of a printed circuit, while its opposite free end applies itself upon another element of the corresponding circuit and may be insulated therefrom through the insertion of an insulating screen, characterized in that :
- the resilient connecting blade (4) has the shape of a laid-down S, the ends of which are each carrying an angled or bent lug (5, 6), one (5) of which forms the end by which said blade (4) is fixed upon an element (1) of the circuit, while the other lug (6) constitutes the movable contact piece bearing against another element (2) of the circuit,
- the support for the elements (1, 2) of the circuit consist in a relatively thin plate (3) presenting an aperture (9) located in registry with the resilient connecting blade (4) and through which is engaged the first loop (7) formed by said blade (4) in the vicinity of its terminal fixation lug (5), the dimension (e) of said aperture (9) in the longitudinal direction being smaller than the maximum width (E) of the corresponding loop (7) of the connecting blade (4) prior to the setting into place of said blade (4).

2. An electric connector according to Claim 1, characterized in that, instead of a simple insulating screen intended for being inserted under the lug (6) on the free end of the resilient connecting blade (4), there is provided a movable element (10b) carrying a conductive track (2b) for a link-up with an external apparatus, so that the insertion of said element (10b) under the free end of the connecting blade (4) will allow a link-up to be made with said external apparatus.

3. An electric printed circuit comprising several tracks connected by means of connectors provided with a resilient blade (4), characterized in that said connectors are constituted by connectors according to Claims 1 or 2.
